(19) **Europäisches Patentamt / European Patent Office / Office européen des brevets**

(11) **EP 2 690 776 B1**

(12) **EUROPEAN PATENT SPECIFICATION**

(45) Date of publication and mention
of the grant of the patent:
**20.07.2016 Bulletin 2016/29**

(51) Int Cl.:
*H02M 7/12* *(2006.01)*      *G01R 19/00* *(2006.01)*
*G05F 1/10* *(2006.01)*      *H02M 1/42* *(2007.01)*

(21) Application number: **12760211.8**

(22) Date of filing: **16.03.2012**

(86) International application number:
**PCT/JP2012/001868**

(87) International publication number:
**WO 2012/127842 (27.09.2012 Gazette 2012/39)**

(54) **POWER CONVERSION DEVICE**

LEISTUNGSWANDLER

DISPOSITIF DE CONVERSION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.03.2011 JP 2011061958**
**11.01.2012 JP 2012002734**

(43) Date of publication of application:
**29.01.2014 Bulletin 2014/05**

(73) Proprietor: **Panasonic Corporation Osaka 571-8501 (JP)**

(72) Inventors:
• **DAI, Xinhui**
  **Osaka-shi, Osaka 540-6207 (JP)**
• **DOYAMA, Yoshiaki**
  **Osaka-shi, Osaka 540-6207 (JP)**
• **KYOGOKU, Akihiro**
  **Osaka-shi, Osaka 540-6207 (JP)**
• **YOSHIDA, Izumi**
  **Osaka-shi, Osaka 540-6207 (JP)**
• **KAWASAKI, Tomohiro**
  **Osaka-shi, Osaka 540-6207 (JP)**

(74) Representative: **Eisenführ Speiser Patentanwälte Rechtsanwälte PartGmbB Postfach 31 02 60 80102 München (DE)**

(56) References cited:
**EP-A1- 0 695 679      JP-A- 2003 079 050**
**JP-A- 2003 250 298      JP-A- 2009 072 022**
**US-A- 4 317 975      US-A- 5 498 984**
**US-A- 5 777 866**

**Description**

Technical Field

The present invention relates to a power conversion device for converting an alternating-current (AC) power supply to a direct current (DC) to drive a DC load, and a power conversion device for converting an AC power supply to a DC and further converting it to another AC to drive an AC load. The present invention particularly relates to a power conversion device which rectifies an AC, such as a single-phase AC power supply in the home and the like, to a substantial DC, and re-converts the obtained DC to an AC with an arbitrary frequency by means of an inverter circuit, to drive a load such as an electric motor at a variable speed, thereby being applicable to, for example, one that constitutes a heat pump provided with a compressor for compressing a refrigerant, and performs cooling, heating, or freezing of food or the like. The power conversion device according to the present invention is provided with a control circuit having a simple configuration, and realizes reduction in harmonic component contained in a power supply current and improvement in power factor.

Background Art

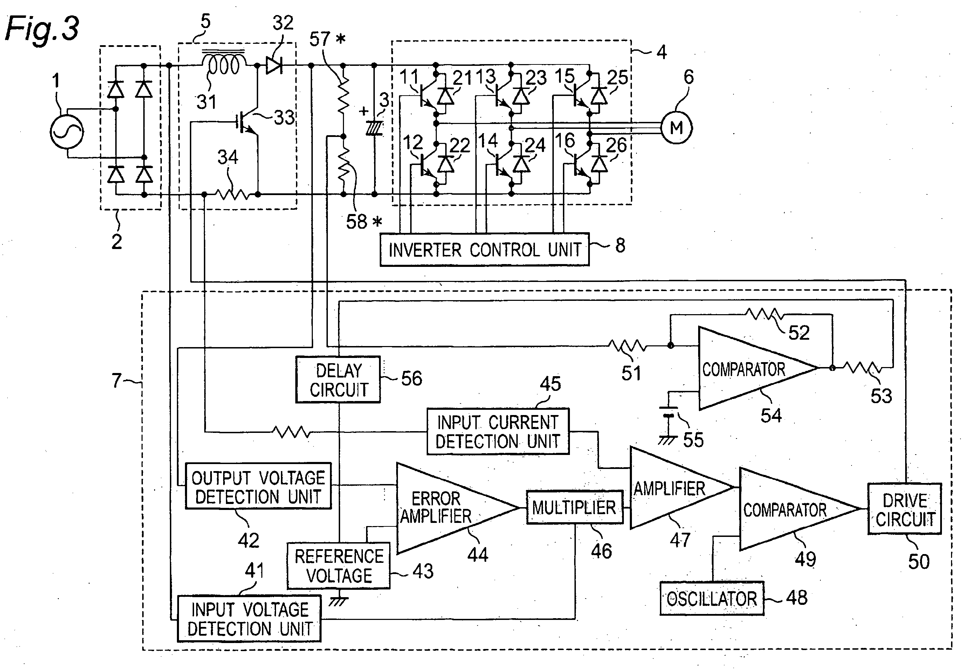

As shown in FIG. 3, a rectifier of this kind rectifies an AC power supply 1 with a diode bridge 2. Subsequently, the current is short-circuited with a semiconductor switch 33 via a reactor 31, the reactor 31 is charged with the current, and when the semiconductor switch 33 comes into an off-state, electric power is supplied to a smoothing capacitor 3 connected to a load by a diode 32. That is, a power supply current flows even in a period when an instant voltage of the AC power supply 1 is low. This leads to reduction in harmonic component in the power supply current and improvement in power factor. Particularly for size reduction in circuit components as well as improvement in power factor, the power supply current is detected, and an on/off of the foregoing semiconductor switch 33 is controlled such that the current has the same waveform as a power supply voltage waveform. It is to be noted that a description of a specific control method for the detected power supply current has already been made in conventional examples, and it will thus be omitted (e.g., see Patent Document 1).

Further, on the load side, by on/off-control of a semiconductor switch group of an inverter circuit 4, a pseudo-DC power supply smoothed by the smoothing capacitor 3 is converted to a pseudo-three-phase AC, to drive a three-phase motor 6 and obtain power so as to activate a heat pump or the like.

In the configuration of FIG. 3, as a method of detecting the current, a resistor 34 (hereinafter referred to as shunt resistor) is inserted between the negative side of the diode bridge 2 and the semiconductor switch 33. A voltage drop due to the resistor is taken as a current value (e.g. see Patent Document 1).

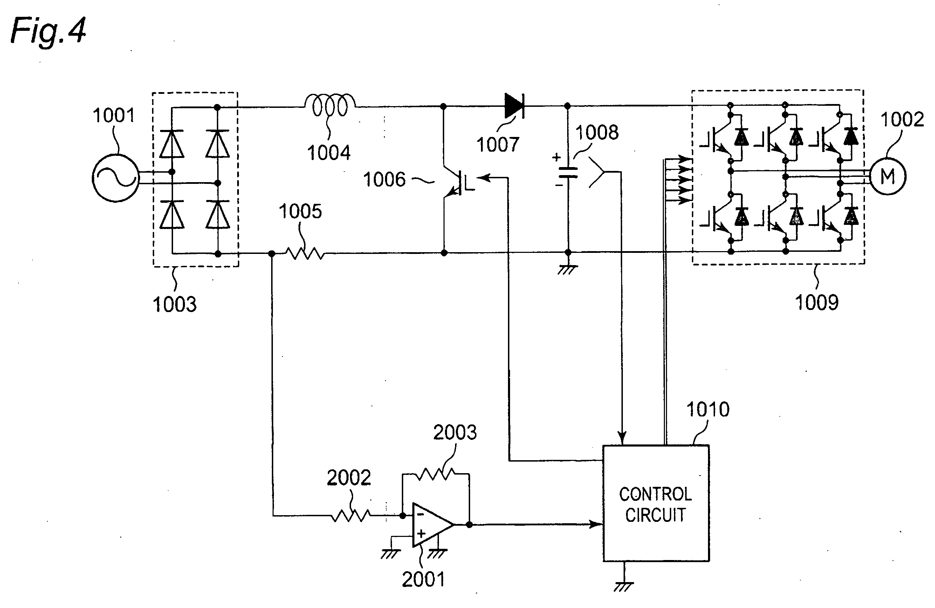

FIG. 4 is a circuit diagram showing a circuit often used for making the current detecting method that is shown in FIG. 3 usable in actual control. A terminal on the AC power supply 1001 side of a shunt resistor 1005 is inputted to the inverting input side of an operational amplifying circuit 2001 via a resistor 2002. A potential on the non-inverting input side of the operational amplifying circuit 2001 is the same as that on the other end of the shunt resistor 1005, and the same as that on the negative side of a power supply input of each of the operational amplifying circuit 2001 and a control circuit 1010.

In such a manner, the power supply can be shared between the operational amplifying circuit 2001 and the control circuit 1010, and further, the power conversion device can be configured of a so-called single power supply circuit system in which the negative side of the power supply input is taken as a reference potential. It is to be noted that one-end potential of the shunt resistor 1005 is a lower voltage than the reference potential, but it is inverted and amplified by the operational amplifying circuit 2001, and when inputted into the control circuit 1010, it has reliably been converted to a higher voltage than the reference potential. For this reason, even when there is a place in part of the circuit in which a potential is lower than the reference potential, only a voltage equal to or higher than the reference potential is inputted into the operational amplifying circuit 2001 and the control circuit 1010, thus allowing an operation by a single power supply circuit.

Then, in the control circuit 1010, an on/off of a semiconductor switch 1006 is controlled such that the power supply flowing from the AC power supply 1001 has a sine-wave form. Further, the control circuit 1010 controls an inverter circuit 1009 to implement drive control so as to allow appropriate rotation of a motor 1002.

Patent Document 3 forming the closest prior art document for the present invention, discloses a power factor correction system with an EMI line filter at the input which includes circuitry to sense the copacetic current of the EMI filter to improve the accuracy of the power factor enhancement. The circuitry consists of a current sensing means connected after the EMI filter, and a voltage sensing capacitor which derives its input signal from a pair of diodes separated from the conventional 4-diode rectifier bridge, which are connected either before or after the EMI filter. The current-sensing means, which may be a resistor, and a voltage-sensing capacitor are tightly coupled to the current control loop or the power factor correction system to compensate the current in the EMI filter capacitors.

Furthermore, Patent Document 4 discloses a power steering apparatus for use in association with an electric motor which includes a switch circuit driven by a PWM wave signal switching between one polarity and the other of the voltage developed across a motor-driven current detecting resistance synchronously with PWM wave signal so as to detect the magnitude and direction of the motor-driving current, thereby controlling a duty cycle of the PWM wave signal in accordance with the detected motor-driving current.

Moreover, Patent Document 5 describes a self-contained, bi-polar high-side current sense amplifier which detects the magnitude and polarity of current flowing from one device to another. The amplifier has a symmetric architecture having two inputs and two outputs. One output is active for positive inputs signals corresponding to current flow in one direction, and the other output is active for negative input signals corresponding to current flow in an opposite direction.

Prior Art Documents

Patent Documents

Patent Document 1: JP 2003-79050 A
Patent Document 2: JP 2003-250298 A
Patent Document 3: US 5,777,866
Patent Document 4: EP 0 695 679 A1
Patent Document 5: US 5,498,984

Summary of Invention

Problem to be Solved by the Invention

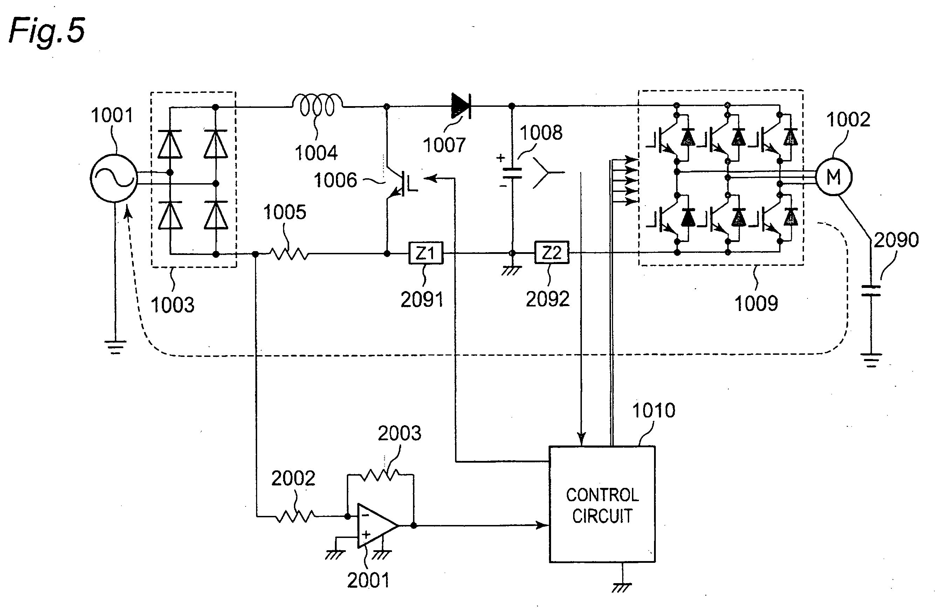

However, in the conventional configuration, as shown in FIG. 5, when a circuit such as the inverter circuit 1009 which drives the motor 1002 by a pulse operation is present on the load side, impedances 2091, 2092 of the wire may cause occurrence of a potential difference from the inverter circuit 1009 in accordance with the pulse, and further a pulse-like current with the same phase may flow due to a stray capacitance 2090 via the motor 1002 through a ground, as indicated by a broken line. Therefore, in the circuit as shown in FIG. 5, not only that noise in the positive direction and noise in the negative direction are superimposed and the current cannot be accurately detected, but also that destruction of the operational amplifying circuit 2001 may be induced.

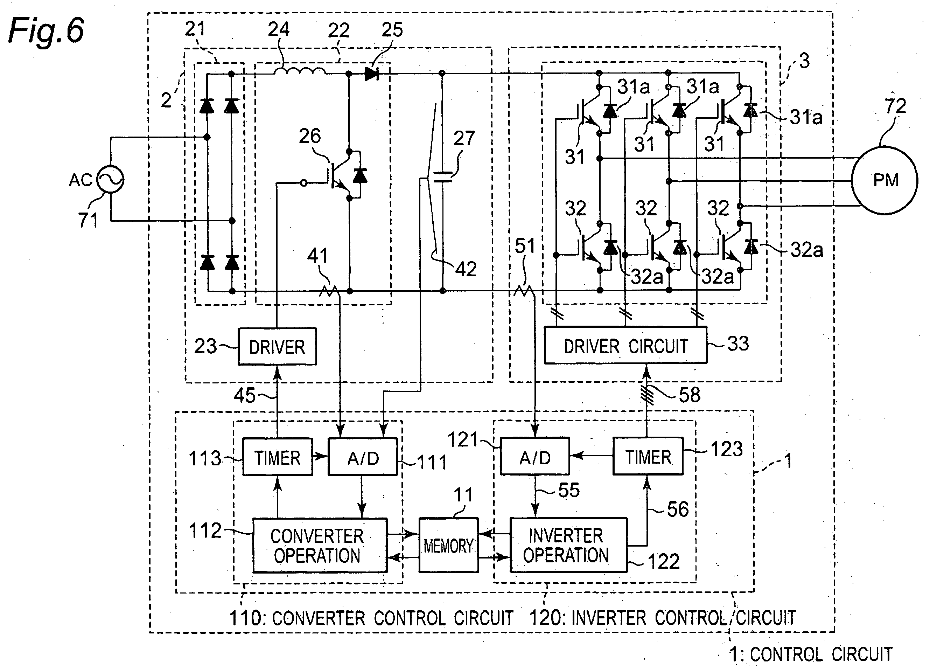

For this reason, a control power supply of a power factor correction circuit 5 and a control power supply on the inverter circuit 4 side in FIG. 3 are separately configured. Between the two control systems with potentials not agreeing with each other, mutual control is performed by insulation-type communication, such as a photocoupler. Further, there is also another method as shown in FIG. 6 in which not the resistor but one insulated from the side to be detected, such as current sensors 41, 51, is used as the current detecting means (e.g., see Patent Document 2).

A problem in the former case is that separate power supply circuits are required and fine control of the two control systems is difficult to realize. A problem in the latter case is that a low-cost resistor cannot be used as the current detecting means.

The present invention has been made to solve the conventional problems, and has an object to provide a power conversion device in which a control power supply is shared between the power supply power factor correction circuit side and the inverter side, and control by a low-cost current detection by means of a resistor is realized.

Means for Solving the Problem

In order to solve the conventional problems, in a power conversion device of the present invention, a resistor is inserted between an output terminal on a negative side of a rectifying diode bridge and a semiconductor switch circuit for power factor correction, both ends of the resistor are inputted to circuits configured to perform inversion and level shifting, and outputs of inverting/level-shifting circuits are inputted to a differential circuit, to acquire current detection information, and the semiconductor switch circuit is on/off-controlled by use of the acquired current detection information.

Accordingly, even when potentials at both ends of the resistor are disturbed with respect to a reference potential of the circuit, they do not deviate from an operation range of the circuit, and it is thereby possible to constantly obtain accurate current information.

Further, a resistor on an input side of the circuit configured to perform inversion and level shifting may be divided into two in series, and a capacitor may be connected between a connection point of the two resistors and a terminal on a negative side of a control power supply. This can suppress disturbance of a potential in a high frequency region in which an amplification degree decreases in an amplification circuit portion of the circuit which performs inversion and level shifting.

Further, the resistor on the input side of the circuit configured to perform inversion and level shifting may be divided into two in series, and a diode may be connected between the connection point of the two resistors and the terminal on the negative side of the control power supply of the circuit such that a current flows toward the connection point.

Accordingly, when there is very large disturbance of the potential, a decrease in potential at the connection point is restricted via the diode, thereby preventing an excessive voltage from entering the amplification circuit portion, to allow protection of the amplification circuit.

Moreover, circuit constants of the inverting/level-shifting circuit and the differential circuit may be set such that a gain of the inverting/level-shifting circuit is smaller than a gain of the differential circuit. Accordingly, even when the potentials at both ends of the resistor for current detection are disturbed in a large degree, the output of the inverting/level-shifting circuit falls within a linear operation range of the circuit, and a disturbance amount is cancelled by the differential circuit, thereby allowing further improvement in noise resistance in the entire current detecting means.

Effects of the Invention

The power conversion device of the present invention can make the control power supply shared between the power supply power factor correction circuit side and the inverter side, while realizing current detection in the power supply power factor correction circuit by use of the resistor. Further, since it can be realized by a so-called single power supply circuit in which the negative potential side of the control power supply is a reference potential, the control circuit can be reduced in size and simplified.

Brief Description of Drawings

FIG. 1 is a circuit block diagram of a power conversion device according to a first embodiment of the present invention.
FIG. 2 is a circuit block diagram of a power conversion device according to a second embodiment and a third embodiment of the present invention.
FIG. 3 is a circuit block diagram of a conventional power conversion device.
FIG. 4 is a circuit block diagram for illustrating a current detection principle of the conventional power conversion device.
FIG. 5 is a circuit block diagram for illustrating a problem in a circuit of the conventional power conversion device.
FIG. 6 is a circuit block diagram of another conventional power conversion device

Description of Embodiments

The invention is defined by the features of claim 1. The dependent claims recite advantageous embodiments of the invention. In particular, a power conversion device is described which converts an AC power supply to a DC for a DC load, or converts it to a pseudo-AC with an arbitrary frequency and amplitude, wherein a resistor is inserted between an output terminal on a negative side of a rectifying diode bridge configured to rectify the AC power supply and a semiconductor switch circuit for power factor correction of the power supply, both ends of the resistor are respectively inputted to circuits configured to perform inversion and level shifting, and outputs of respective inverting/level-shifting circuits are inputted to a differential circuit, to acquire current detection information, and the semiconductor switch circuit is on/off-controlled by use of the acquired current detection information such that a harmonic component contained in the power supply current is reduced or a power factor from the AC power supply is improved, whereby, even in the case of fluctuations in potential of the inserted resistor due to noise, level shifting to an operation range of the differential circuit is performed by the circuit which performs inversion and level shifting, and it is thus possible to remove a fluctuation component by means of the differential circuit and accurately detect the current from the AC power supply, so as to reduce the harmonic component contained in the power supply current and improve the power factor.

According to a preferred embodiment of the present invention, in particular, a level potential which is a reference of the inverting/level-shifting circuit in the first aspect of the present invention, is made to be a higher potential than a lowest potential in a circuit unit for performing conversion to the DC load output or the pseudo-AC with an arbitrary frequency and amplitude. Hence the potential to be inputted into the circuit which performs inversion and level shifting is held higher than the lowest potential, thereby eliminating the need for using the circuit which performs inversion and level shifting and has a broad voltage input range, to facilitate circuit designing.

According to a further embodiment of the present invention, in particular, the resistor on the input side of the inverting/level-shifting circuit in the first or second aspect of the present invention is divided into two in series, and a capacitor is connected between a connection point of the two resistors and a terminal on the negative side of the control power supply of the circuit, and hence an abrupt noise component, to which the circuit which performs inversion and level shifting cannot respond, can be removed, thereby eliminating the need for using the circuit which performs inversion and level shifting with fast-response performance, to facilitate circuit designing.

According to a further embodiment of the present invention, in particular, a time constant is determined in accordance with a parallel value of the two divided resistors in the third aspect of the present invention and a capacitance value of the capacitor, and the time constant is made smaller than a period of the on/off-control of the semiconductor switch, thereby having no influence on a band of the on/off-control of the semiconductor switch, to allow appropriate and stable realization of reduction in harmonic component contained in a power supply current and improvement in power factor.

According to a further embodiment of the present invention, in particular, the resistor, in each of the first to fourth aspects of the present invention, on the input side of the circuit which performs inversion and level shifting is divided into two in series, and a diode is connected between the connection point of the two resistors and the terminal on the negative side of the control power supply of the circuit such that a current flows toward the connection point. Accordingly, when noise having a negative voltage, beyond an allowable range of the inverting/level-shifting circuit is mixed in, the diode is conducted to constrain the voltage, thereby eliminating the need for using the circuit which performs inversion and level shifting with a broad voltage input range, to facilitate circuit designing.

According to a further embodiment of the present invention, in particular, the power supply for controlling and activating the inverting/level-shifting circuit and the differential circuit in each of the first to fifth aspects of the present invention is a DC power supply having a lowest potential of a drive control circuit for the DC load or a control circuit in the circuit unit for performing conversion to the pseudo-AC with an arbitrary frequency and amplitude and having a higher potential than the lowest potential, and the following potentials are made equal: a potential on the negative side of the DC power supply which activates and controls a means for reducing harmonic component in the current of the AC power supply or controlling power factor correction and a potential on the negative side of the DC power supply which activates and controls the circuit unit for performing conversion to the DC load or the pseudo-AC with an arbitrary frequency and amplitude.

Accordingly, the power supply associated with the activation/control can be shared, thereby eliminating the need for providing individual control power supplies, to allow reduction in size of the control power supply as well as reduction in size of the drive control circuit.

According to a further embodiment of the present invention, in particular, circuit constants of the inverting/level-shifting circuits and the differential circuit may be set such that a gain of the inverting/level-shifting circuit in each of the first to sixth aspects of the present invention is smaller than a gain of the differential circuit.

Accordingly, even when the potentials at both ends of the resistor for current detection are disturbed in a large degree, the output of the inverting/level-shifting circuit falls within a linear operation range of the circuit, and a disturbance amount is cancelled by the differential circuit, thereby allowing further improvement in noise resistance in the entire current detecting means. Further, when the circuit which performs inversion and level shifting includes an operation amplified, the operation amplifier need not have a broad output voltage range, so as to facilitate circuit designing.

Hereinafter, embodiments of the present invention will be described with reference to the drawings. It is to be noted that these embodiments do not restrict the present invention.

(First Embodiment)

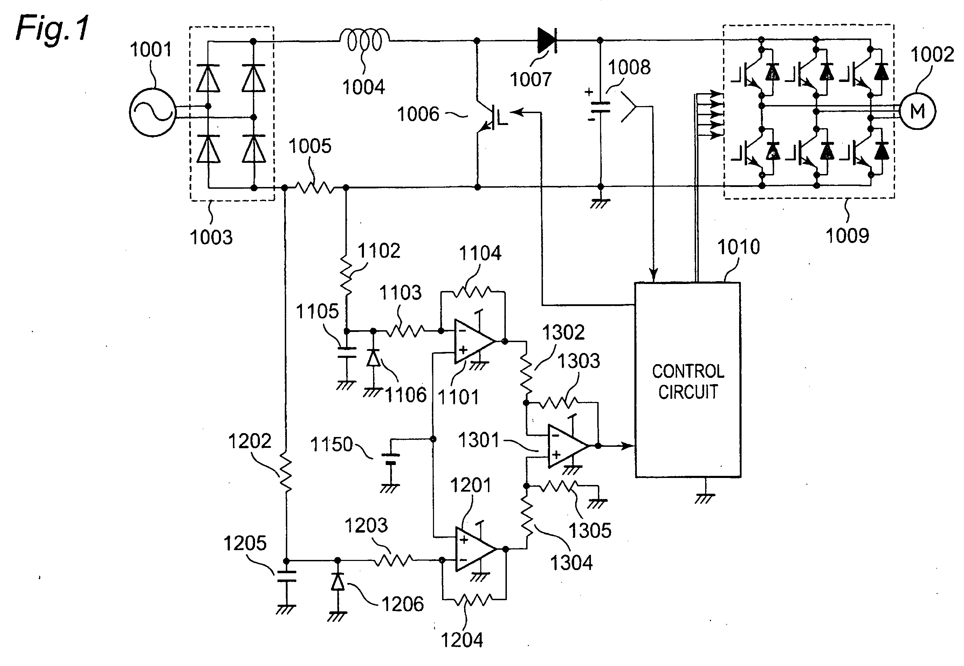

FIG. 1 is an entire circuit block diagram of a power conversion device according to a first embodiment of the present invention.

In FIG. 1, an AC power supply 1001 is connected to a diode bridge 1003, and is rectified. The positive side of a rectification output is connected to a semiconductor switch 1006 and a diode 1007 through a reactor 1004. The other end of the diode 1007 is connected to a smoothing capacitor 1008. The negative side of the rectification output is connected to the semiconductor switch 1006 and the smoothing capacitor 1008 through a shunt resistor 1005. By these circuits, the output of the AC power supply 1001 is rectified and smoothed, to constitute a power supply of a substantially DC. Particularly, turning on/off the semiconductor switch 1006 allows a current to flow from the AC power supply 1001 even in a period when the voltage of the AC power supply 1001 is low, thus leading to improvement in power factor and reduction in harmonic current of the power supply. The electric power having been made a substantially DC by the smoothing capacitor 1008 is converted to another pseudo-AC by an inverter circuit 1009, to drive a motor 1002. A reference potential (zero potential) of a group of these circuits is placed on the negative side of the smoothing capacitor 1008.

The current from the AC power supply 1001 is detected by means of a potential, difference between both ends of the shunt resistor 1005. This information of the voltages at both ends is inputted into a first inverting/level-shifting circuit and a second inverting/level-shifting circuit. The first inverting/level-shifting circuit includes a reference voltage source 1150, resistors 1102, 1103, 1104 and an operational amplifying circuit 1101 and performs inversion and level shifting. The second inverting/level-shifting circuit includes the reference voltage source 1150, resistors 1202, 1203, 1204 and an operational amplifying circuit 1201. It should be noted that a capacitor 1105 and a diode 1106 are arranged between a connection point of the resistors 1102 and 1103 and a reference potential (zero potential), and a capacitor 1205 and a diode 1206 are arranged between a connection point of the resistors 1202 and 1203 and a reference potential (zero potential). Further, the reference potential (zero potential) is used on the negative sides of power supplies which drive the operational amplifying circuits 1101, 1201.

Outputs of the operational amplifying circuits 1101, 1201 are respectively inputted into resistors 1302, 1304, to activate a differential circuit which includes resistors 1302, 1303, 1304, 1305 and an operational amplifying circuit 1301. A difference between the outputs of the operational amplifying circuits 1101, 1201 is extracted, and an output of the operational amplifying circuit 1301 is inputted into a control circuit 1010 as a current detection result.

The control circuit 1010 is realized by a microcomputer or the like, and in accordance with an excess and deficiency of the detected current, a ratio for turning on/off the semiconductor switch 1006 is adjusted, resulting in adjustment of the input current. Further, the control circuit 1010 can also control the inverter 1009.

Concerning the power conversion device as thus configured, its operation and action will be described below.

When the motor 1002 as a load is driven, a current flows from the AC power supply 1001, and a potential difference occurs in the shunt resistor 1005. Since a direction in which the current flows through the shunt resistor 1005 is a direction from the right to the left in the figure, a potential on the smoothing capacitor 1008 side is the reference potential (zero potential), and a potential on the diode bridge 1003 side is a lower potential. An output voltage Vo_1 of the operational amplifying circuit 1101 is expressed by the following formula when a resistor potential on the smoothing capacitor 1008 side is V0, a potential in a reference voltage source 1150 is Vref and values of the respective resistors 1102, 1103, 1104 are R1102, R1103, R1104.

$$
\begin{aligned}
\mathrm{Vo\_1} = \\
\{(\mathrm{R1102}+\mathrm{R1103}+\mathrm{R1104})/(\mathrm{R1102}+\mathrm{R1103})\}\mathrm{Vref} \\
- \{\mathrm{R1104}/(\mathrm{R1102}+\mathrm{R1103})\}\mathrm{V1} \qquad\qquad (\text{Formula 1})
\end{aligned}
$$

Similarly, an output voltage Vo_2 of the operational amplifying circuit 1201 is expressed by the following formula when a potential on the diode bridge side is V2, the potential in the reference voltage source 1150 is Vref and values of the respective resistors 1202, 1203, 1204 are R1202, R1203, R1204.

$$
\begin{aligned}
\mathrm{Vo\_2} = \\
\{(\mathrm{R1202}+\mathrm{R1203}+\mathrm{R1204})/(\mathrm{R1202}+\mathrm{R1203})\}\mathrm{Vref} \\
- \{\mathrm{R1204}/(\mathrm{R1202}+\mathrm{R1203})\}\mathrm{V2} \qquad\qquad (\text{Formula 2})
\end{aligned}
$$

Herein, Vref is a positive value, V1 is substantially zero and V2 is a negative value, and hence both Vo_1 and Vo_2 are positive values higher than Vref. That is, even when the values of V1 and V2 are disturbed by some noise, the outputs are positive potentials, and the operational amplifying circuits 1101, 1201 appropriately operate.

Next, an operation of the capacitor 1105 will be described. By connecting the capacitor 1105, an abrupt noise generated at each end of the shunt resistor 1005 is absorbed by the resistors 1102, 1103 and the capacitor 1105. Since the abrupt component is absorbed in the terminal of the capacitor 1105, the abrupt component is also attenuated from the output of the circuit formed by the resistors 1103, 1104 and the operational amplifying circuit 1101. That is, even a noise component beyond the band of the operational amplifying circuit 1101 can be attenuated. The capacitor 1205 operates in a similar manner. A frequency of the attenuation by the capacitor 1105 is desirably set higher than a frequency in the on/off-control of the semiconductor switch 1006 in consideration of an influence by the semiconductor switch 1006 on a feedback control system.

Next, an operation of the diode 1106 will be described. Since the potential of the terminal connected to the diode 1106 is normally set to a positive potential, it is not related to the operation of the operational amplifying circuit 1101. However, in the case of first charging of the smoothing capacitor 1008 or some other case, when an excessive current flows, the potential of the shunt resistor 1005 becomes very low. There are then some cases where the potential exceeds a region for operation of the operational amplifying circuit 1101, the potential of the input terminal of the operational amplifying circuit 1101 is lower than the reference potential (zero potential) as the power supply of the operational amplifying circuit 1101 and the operational amplifying circuit 1101 may break down. It is thus required to select the operational amplifying circuit 1101 having a larger input voltage range than the power supply voltage range. However, with the diode 1106 previously provided, the potential of the input terminal of the operational amplifying circuit 1101 does not become equal to or less than the reference potential (zero potential), and it is thus possible to use the operational amplifying circuit 1101 having an input voltage range within the power supply voltage range.

As thus described, the outputs of the operational amplifying circuits 1101, 1201 can linearly operate even in the case of superimposition of noise, and hence, inputting the outputs into the differential circuit including the resistors 1302, 1303, 1304, 1305 and the operational amplifying circuit 1301 allows detection of an input current with the noise component cancelled.

Since the negative side of the power supply to activate can be shared among all of these circuits, it is possible to simplify the power supply circuit. Further, control of driving the inverter 1009 is also performed by the same control circuit 1010, thereby facilitating realization of fine power conversion control in accordance with the load state.

(Second Embodiment)

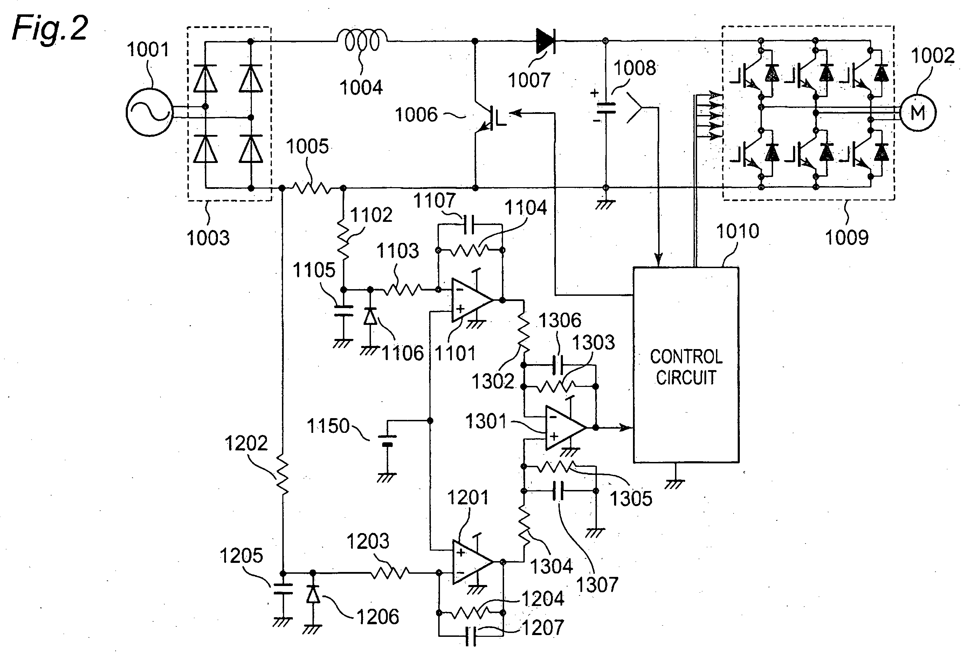

FIG. 2 is a circuit block diagram of a power conversion device according to a second embodiment of the present invention. In FIG. 2, a basic operation and the like are similar to that of the first embodiment, and only differences therefrom will be described.

A first difference is that capacitors 1107, 1207 are provided in parallel with the resistors 1104, 1204 in negative feedback systems of the operational amplifying circuits 1101, 1201. This can further increase the characteristics of attenuating the high frequency component by means of the inverting/level-shifting circuit formed by the operational amplifying circuits 1101, 1201.

A second difference is that capacitors are provided in parallel with the resistors 1303, 1305 in the differential circuit formed by the operational amplifying circuit 1301. This can attenuate a high frequency component in the differential circuit.

That is, adding the first difference and the second difference can remove a variety of noise components that are mixed into the current detection means by use of the shunt resistor 1005. Hence the accuracy in control of the power supply current is enhanced, to alleviate a load of a transmission system and to enhance the usage efficiency of the power supply.

(Third Embodiment)

A third embodiment of the present invention will be described in FIG. 2. A basic operation is similar to that in the first and second embodiments, and hence a description thereof will be omitted.

In FIG. 2, the output voltage of the inverting/level-shifting circuit 1101 is expressed by (Formula 1), and a gain Av_1 with respect to the input voltage is expressed by the following formula.

$$\text{Av\_1} = \text{R1104/(R1102+R1103)} \qquad \text{(Formula 3)}$$

Similarly, the output voltage of the inverting/level-shifting circuit 1201 is expressed by (Formula 2), and a gain Av_2 with respect to the input voltage is expressed by the following formula.

$$\text{Av\_2} = \text{R1204/(R1202+R1203)} \qquad \text{(Formula 4)}$$

From Formulas 1, 2, the outputs of the inverting/level-shifting circuits are related to the gains of the respective circuits. In the case of disturbance of the potential at each end of the resistor for current detection, when the gains are large, the outputs of the inverting/level-shifting circuits greatly change. That is, the disturbance of the potential at each end of the resistor is expanded by the gains of the circuits. Small disturbance of the potential may be expanded by the gains of the circuits, and the outputs of the inverting/level-shifting circuits may exceed the linear operation range of the circuits, and in that case, an amount of the disturbance cannot be cancelled in the differential amplification circuit, and the noise resistance of the entire current detecting means deteriorates.

On the other hand, the differential amplification circuit is less susceptible to the same noise that enters two inputs, thereby allowing an increase in gains of the circuits.

Accordingly, by setting the circuit constants of the inverting/level-shifting circuits and the differential circuit such that the gains of the inverting/level-shifting circuits are smaller than the gain of the differential circuit, it is possible to ensure a necessary total gain of the current detecting means, and also to ensure a noise margin of the entire current detecting means.

Industrial Applicability

As thus descried, a power conversion device according to the present invention can enhance the usage efficiency of a power supply, thereby being applicable to, for example one which constitutes a heat pump by means of a compressor compressing a refrigerant and performs cooling/heating, or freezing/chilling of food or the like.

Reference Signs List

    1001 AC power supply
    1005 shunt resistor
    1008 smoothing capacitor
    1102, 1103, 1104, 1202, 1203, 1204, 1302, 1303, 1304, 1305 resistor
    1101, 1201, 1301 operational amplifying circuit
    1010 control circuit
    1105, 1107, 1205, 1207, 1306, 1307 capacitor
    1106, 1206 diode
    1150 reference voltage source

**Claims**

1.  A power conversion device, which comprises a rectifying diode bridge (1003) configured to rectify an AC power supply (1001), a semiconductor switch circuit (1006) for power factor correction of the power supply (1001), which converts the current from the AC power supply (1001) to a DC to drive a DC load, or converts the DC to a pseudo-AC with an arbitrary frequency and amplitude to drive an AC load, and
    a shunt resistor (1005) that is inserted between an output terminal on a negative side of the rectifying diode bridge (1003); and the semiconductor switch circuit (1006);
    **characterized by**:

        a first inverting/level-shifting circuit (1101 - 1104, 1150) configured to perform inversion and level shifting;
        a second inverting/level-shifting circuit (1201 - 1204, 1150) configured to perform inversion and level shifting; and
        a differential circuit (1301-1305) configured to output as current detection information a signal indicating a difference between the output of the first inverting/level-shifting circuit (1101 - 1104, 1150), and the output of the second inverting/level-shifting circuit (1201 - 1204, 1150), wherein
        one end of the resistor (1005) is connected to only the first inverting/level-shifting circuit (1101 - 1104, 1150), and the other end of the resistor (1005) is connected to only the second inverting/level-shifting circuit (1201 - 1204, 1150),
        outputs of the first and second inverting/level-shifting circuits (1101 - 1104, 1150; 1201 - 1204, 1150), are inputted to the differential circuit (1301 - 1305), and
        the semiconductor switch circuit (1006) is on/off-controlled by use of the current detection information.

2.  The power conversion device according to claim 1, wherein
    a level potential which is a reference of the first and second inverting/level-shifting circuits (1101 - 1104, 1150; 1201 - 1204, 1150) is made to be a higher potential than a lowest potential in a circuit unit configured to perform conversion to the DC load output or the pseudo-AC with an arbitrary frequency and amplitude.

3.  The power conversion device according to claim 1 or 2, further comprising
    two resistors (1102, 1103; 1202; 1203) connected in series that are provided on an input side of each of the first and second inverting/level-shifting circuits (1101 - 1104, 1150; 1201 - 1204, 1150), and
    a capacitor (1105; 1205) that is connected between a connection point of the two resistors (1102; 1103; 1202, 1203) and a terminal on the negative side of a control power supply (1001) of the circuit.

4.  The power conversion device according to claim 3, wherein
    a time constant is determined by means of a parallel value of the two divided resistors (1102, 1103; 1202, 1203) and a capacitance value of the capacitor (1105; 1205), and
a frequency which is determined in accordance with the time constant is lower than a band frequency of an amplifier constituting each of the first and second inverting/level-shifting circuits (1101 - 1104, 1150; 1201 - 1204, 1150).

5. The power conversion device according to claim 3 or 4, wherein
the time constant which is determined by means of the parallel value of the two divided resistors (1102, 1103; 1202, 1203) and the capacitance value of the capacitor (1105; 1205) is smaller than a period for the on/off-control of the semiconductor switch (1006).

6. The power conversion device according to claim 5, wherein
the time constant is one-sixth to one-twentieth as large as the period for the on/off-control of the semiconductor switch (1006).

7. The power conversion device according to any one of claims 1 to 6, wherein
at least either circuit of the first and second inverting/level-shifting circuits (1101 - 1104, 1150; 1201 - 1204, 1150) or the differential circuit (1301 - 1305) has characteristics of attenuating a higher frequency component than the frequency for on/off-controlling the semiconductor switch (1006).

8. The power conversion device according to claim 1 or 2, further comprising
two resistors (1102, 1103; 1202, 1203) connected in series that are provided on the input side of each of the first and second inverting/level-shifting circuits (1101 - 1104, 1150; 1201 - 1204, 1150), and
a diode (1106; 1206) that is connected between a connection point of the two resistors (1102, 1103; 1202, 1203) and a terminal on a negative side of a control power supply (1001) such that a current flows toward the connection point.

9. The power conversion device according to any one of claims 1 to 8, wherein
a power supply configured to activate the first and second inverting/level-shifting circuits (1101 - 1104, 1150; 1201 - 1204, 1150) and the differential circuit (1301 - 1305) is a DC power supply having a lowest potential of a control circuit (1010) for driving the DC load or a circuit for controlling a circuit unit for performing conversion to the pseudo-AC with an arbitrary frequency and amplitude and a higher potential than the lowest potential.

10. The power conversion device according to claim 9, wherein
potentials are made equal, the potentials being
a potential on a negative side of the DC power supply for activating the first and second inverting/level-shifting circuits (1101 - 1104, 1150; 1201 - 1204, 1150) and the differential circuit (1301 - 1305),
a potential on the negative side of the DC power supply configured to activate and control a means for reducing a harmonic component in the current of the AC power supply (1001) or controlling the power factor correction, and
a potential on the negative side of the DC power supply configured to activate and control the control circuit (1010) for the DC load or the circuit unit for performing conversion to the pseudo-AC with an arbitrary frequency and amplitude.

11. The power conversion device according to any one of claims 1 to 10, wherein
circuit constants of the first and second inverting/level-shifting circuits (1101 - 1104, 1150; 1201 - 1204, 1150) and the differential circuit (1301 - 1305) are set such that a gain of each of the first and second inverting/level-shifting circuits (1101 - 1104, 1150; 1201 - 1204, 1150) is smaller than a gain of the differential circuit (1301 - 1305).

12. The power conversion device according to any one of claims 3 to 6, further comprising
a diode (1106; 1206) that is connected between the connection point of the two resistors (1102, 1103; 1202, 1203) and the terminal on the negative side of the control power supply (1001) such that a current flows toward the connection point.

**Patentansprüche**

1. Leistungswandlervorrichtung, die eine Gleichrichterdiodenbrücke (1003) umfasst, die ausgebildet ist, eine Wechselstromversorgung (1001) gleichzurichten, eine Halbleiterschalter-Schaltung (1006) zur Leistungsfaktorkorrektur der Stromversorgung (1001), die den Strom der Wechselstromversorgung (1001) zu einem Gleichstrom konvertiert, um eine Gleichstromlast zu treiben, oder die den Gleichstrom zu einem Pseudo-Wechselstrom konvertiert mit einer beliebigen Frequenz und Amplitude zum Treiben einer Wechselstromlast, und
ein Nebenschlusswiderstand (1005), der zwischen einem Ausgangsanschluss auf einer negativen Seite der Gleichrichterdiodenbrücke (1003) und der Halbleiterschalter-Schaltung (1006) eingefügt ist;
**gekennzeichnet durch**:

eine erste Wechselrichter/Pegelverschiebungs-Schaltung (1101 - 1104, 1150), die konfiguriert ist, eine Umkehrung oder Pegelverschiebung durchzuführen;
eine zweite Wechselrichter/Pegelverschiebungs-Schaltung (1201 - 1204, 1150), die konfiguriert ist, eine Umkehrung oder Pegelverschiebung durchzuführen; und
eine Differenzialschaltung (1301 - 1305), die konfiguriert ist, als Stromerfassungsinformation ein Signal auszugeben, das eine Differenz zwischen dem Ausgang der ersten Wechselrichter/Pegelverschiebungs-Schaltung (1101 - 1104, 1150) und dem Ausgang der zweiten Wechselrichter/Pegelverschiebungs-Schaltung (1201 - 1204, 1150) angibt; wobei
ein Ende des Widerstands (1005) nur mit der ersten Wechselrichter/Pegelverschiebungs-Schaltung (1101 - 1104, 1150), und das andere Ende des Widerstands (1005) nur mit der zweiten Wechselrichter/Pegelverschiebungs-Schaltung (1201 - 1204, 1150) verbunden ist,
Ausgänge der ersten Wechselrichter/Pegelverschiebungs-Schaltung (1101 - 1104, 1150), und der zweiten Wechselrichter/Pegelverschiebungs-Schaltung (1201 - 1204, 1150) in die Differenzialschaltung (1301 - 1305) eingehen, und
die Halbleiterschalter-Schaltung (1006) **durch** die Nutzung der Stromerfassungsinformation An/Aus-gesteuert ist.

2. Leistungswandlervorrichtung nach Anspruch 1, wobei
ein Pegelpotential, das eine Referenz für die erste und zweite Wechselrichter/Pegelverschiebungs-Schaltung (1101 - 1104, 1150; 1201 - 1204, 1150) ist, derart ausgelegt ist, dass es ein größeres Potential ist als ein niedrigstes Potential in einer Schaltungseinheit, die konfiguriert ist, eine Umwandlung in den Gleichstromlastausgang oder den Pseudo-Wechselstrom mit einer beliebigen Frequenz und Amplitude durchzuführen.

3. Leistungswandlervorrichtung nach Anspruch 1 oder 2, ferner umfassend
zwei in Reihe geschaltete Widerstände (1102, 1103; 1202, 1203), die auf einer Eingangsseite von jeder der ersten und zweiten Wechselrichter/Pegelverschiebungs-Schaltungen (1101 - 1104, 1150; 1201 - 1204, 1150) vorgesehen sind, und
einen Kondensator (1105; 1205), der zwischen einem Verbindungspunkt der beiden Widerstände (1102, 1103; 1202, 1203) und einem Anschluss auf der negativen Seite einer Steuerungsstromversorgung (1001) der Schaltung verbunden ist.

4. Leistungswandlervorrichtung nach Anspruch 3, wobei
eine Zeitkonstante mittels eines Parallelwertes der beiden geteilten Widerstände (1102, 1103; 1202, 1203) und eines Kapazitätswertes des Kondensators (1105; 1205) bestimmt wird, und
eine Frequenz, die in Übereinstimmung mit der Zeitkonstante bestimmt wird, niedriger ist als ein Frequenzband eines Verstärkers, der jede der ersten und zweiten Wechselrichter/Pegelverschiebungs-Schaltungen (1101 - 1104, 1150; 1201 - 1204, 1150) bildet.

5. Leistungswandlervorrichtung nach Anspruch 3 oder 4, wobei
die Zeitkonstante, die durch den Parallelwert der beiden geteilten Widerständen (1102, 1103; 1202, 1203) und den Kapazitätswert des Kondensators (1105; 1205) bestimmt wird, kleiner ist als eine Zeitdauer für die An-/Aus-Steuerung des Halbleiterschalters (1006).

6. Leistungswandlervorrichtung nach Anspruch 5, wobei die Zeitkonstante ein Sechstel bis ein Zwanzigstel so groß ist wie die Zeitdauer für die Ein-/AusSteuerung des Halbleiterschalters (1006).

7. Leistungswandlervorrichtung nach einem der Ansprüche 1 bis 6, wobei
zumindest jede Schaltung der ersten und zweiten Wechselrichter/Pegelverschiebungs-Schaltungen (1101 - 1104, 1150; 1201 - 1204, 1150) oder die Differenzschaltung (1301 - 1305) Eigenschaften besitzt, eine höhere Frequenzkomponente als die Frequenz für die Ein-/Aus-Steuerung des Halbleiterschalters (1006) zu dämpfen.

8. Leistungswandlervorrichtung nach Anspruch 1 oder 2, ferner umfassend
zwei in Reihe geschaltete Widerstände (1102, 1103; 1202, 1203), die auf der Eingangsseite von jeder der ersten und zweiten Wechselrichter/Pegelverschiebungs-Schaltungen (1101 - 1104, 1150; 1201 - 1204, 1150) vorgesehen sind, und
eine Diode (1106; 1206), die zwischen einem Verbindungspunkt der beiden Widerstände (1102, 1103; 1202, 1203) und einem Anschluss auf einer negativen Seite einer Steuerstromversorgung (1001) verbunden ist, so dass ein Strom in Richtung des Verbindungspunkts fließt.

9. Leistungswandlervorrichtung nach einem der Ansprüche 1 bis 8, wobei
eine Stromversorgung, die konfiguriert ist, die erste und zweite Wechselrichter/Pegelverschiebungs-Schaltung (1101 - 1104, 1150; 1201 - 1204; 1150) und die Differenzialschaltung (1301 - 1305) zu aktivieren, eine Gleichstromversorgung ist, die ein niedrigstes Potential einer Steuerschaltung (1010) zum Treiben der Gleichstromlast oder einer Schaltung zum Steuern einer Schaltungseinheit zur Umwandlung in den Pseudo-Wechselstrom mit einer beliebigen Frequenz und Amplitude und ein höheres Potential als das niedrigste Potential hat.

10. Leistungswandlervorrichtung nach Anspruch 9, wobei
Potentiale gleich gesetzt werden, wobei die Potentiale sind:

ein Potential auf einer negativen Seite der Gleichstromversorgung zur Aktivierung der ersten und zweiten Wechselrichter/Pegelverschiebungs-Schaltung (1101 - 1104, 1150; 1201 - 1204, 1150) und der Differenzschaltung (1301 - 1305),
ein Potential an der negativen Seite der Gleichstromversorgung konfiguriert zum Aktivieren und Steuern von einem Mittel zum Reduzieren einer harmonischen Komponente in dem Strom der Wechselstromversorgung (1001) oder zum Steuern der Leistungsfaktorkorrektur, und
ein Potential an der negativen Seite der Gleichstromversorgung konfiguriert zum Aktivieren und Steuern der Steuerschaltung (1010) für die Gleichstromlast oder der Schaltungseinheit zur Durchführung einer Umwandlung in den Pseudo-Wechselstrom mit einer beliebigen Frequenz und Amplitude.

11. Leistungswandlervorrichtung nach einem der Ansprüche 1 bis 10, wobei
Schaltungskonstanten der ersten und zweiten Wechselrichter/Pegelverschiebungs-Schaltung (1101 - 1104, 1150; 1201 - 1204, 1150) und der Differentialschaltung (1301 - 1305) so eingestellt sind, dass eine Verstärkung von jeder der ersten und zweiten Wechselrichter/Pegelverschiebungs-Schaltungen (1101 - 1104, 1150; 1201 - 1204, 1150) kleiner ist als eine Verstärkung der Differentialschaltung (1301 - 1305).

12. Leistungswandlervorrichtung nach einem der Ansprüche 3 bis 6, ferner umfassend
eine Diode (1106; 1206), die zwischen dem Verbindungspunkt der zwei Widerstände (1102, 1103; 1202, 1203) und dem Anschluss auf der negativen Seite der Steuerstromversorgung (1001) verbunden ist, so dass ein Strom in Richtung des Verbindungspunktes fließt.

**Revendications**

1. Dispositif de conversion de puissance qui comprend un pont de diodes redresseur (1003) configuré pour redresser une alimentation en courant alternatif (1001), un circuit de commutateur à semi-conducteur (1006) pour la correction du facteur de puissance de l'alimentation électrique (1001), qui convertit le courant de l'alimentation en courant alternatif (1001) en un courant continu afin d'entraîner une charge à courant continu, ou qui convertit le courant continu en un pseudo courant alternatif avec des fréquence et amplitude quelconques pour entraîner une charge à courant alternatif, et
une résistance en dérivation (1005) qui est insérée entre une borne de sortie sur un côté négatif du pont de diodes redresseur (1003) et le circuit de commutateur à semi-conducteur (1006);
**caractérisé par**:

un premier circuit onduleur/de décalage de niveau (1101 - 1104, 1150) configuré pour réaliser une inversion ou un décalage de niveau;
un deuxième circuit onduleur/de décalage de niveau (1201 - 1204, 1150) configuré pour réaliser une inversion ou un décalage de niveau; et
un circuit différentiel (1301 - 1305) configuré pour émettre, en tant qu'information de détection de courant, un signal qui indique une différence entre la sortie du premier circuit onduleur/de décalage de niveau (1101 - 1104, 1150) et la sortie du deuxième circuit onduleur/de décalage de niveau (1201 - 1204, 1150); dans lequel
une extrémité de la résistance (1005) n'est connectée qu'au premier circuit onduleur/de décalage de niveau (1101 - 1104, 1150) et l'autre extrémité de la résistance (1005) n'est connectée qu'au deuxième circuit onduleur/de décalage de niveau (1201 - 1204, 1150),
des sorties des premier et deuxième circuits onduleurs/de décalage de niveau (1101 - 1104, 1150; 1201 - 1204, 1150) entrent dans le circuit différentiel (1301 - 1305), et
le circuit de commutateur à semi-conducteur (1006) est commandé on/off en utilisant l'information de détection de courant.

2. Dispositif de conversion de puissance selon la revendication 1, dans lequel
un potentiel de niveau qui est une référence pour les premier et deuxième circuits onduleurs/de décalage de niveau (1101 - 1104, 1150; 1201 - 1204, 1150) est conçu pour être un potentiel supérieur à un potentiel le plus faible dans une unité de circuit configurée pour effectuer une conversion en la sortie de charge à courant continu ou en le pseudo courant alternatif avec des fréquence et amplitude quelconques.

3. Dispositif de conversion de puissance selon la revendication 1 ou 2, comprenant en outre
deux résistances (1102, 1103; 1202, 1203) montées en série qui sont prévues sur un côté d'entrée de chacun des premier et deuxième circuits onduleurs/de décalage de niveau (1101 - 1104, 1150; 1201 - 1204, 1150), et
un condensateur (1105; 1205) qui est connecté entre un point de connexion des deux résistances (1102, 1103; 1202, 1203) et une borne sur le côté négatif d'une alimentation en courant de commande (1001) du circuit.

4. Dispositif de conversion de puissance selon la revendication 3, dans lequel
une constante de temps est déterminée au moyen d'une valeur parallèle des deux résistances (1102, 1103; 1202, 1203) divisées et d'une valeur de capacité du condensateur (1105; 1205), et
une fréquence qui est déterminée en conformité avec la constante de temps est inférieure à une bande de fréquences d'un amplificateur constituant chacun des premier et deuxième circuits onduleurs/de décalage de niveau (1101 - 1104, 1150; 1201 - 1204, 1150).

5. Dispositif de conversion de puissance selon la revendication 3 ou 4, dans lequel
la constante de temps qui est déterminée au moyen de la valeur parallèle des deux résistances (1102, 1103; 1202, 1203) divisées et de la valeur de capacité du condensateur (1105; 1205) est inférieure à une durée pour la commande on/off du commutateur à semi-conducteur (1006).

6. Dispositif de conversion de puissance selon la revendication 5, dans lequel
la constante de temps fait entre un sixième et un vingtième de la durée pour la commande on/off du commutateur à semi-conducteur (1006).

7. Dispositif de conversion de puissance selon l'une quelconque des revendications 1 à 6, dans lequel
au moins chaque circuit des premier et deuxième circuits onduleurs/de décalage de niveau (1101 - 1104, 1150; 1201 - 1204, 1150) ou le circuit différentiel (1301 - 1305) présente des caractéristiques pour atténuer une composante de fréquence supérieure à la fréquence pour la commande on/off du commutateur à semi-conducteur (1006).

8. Dispositif de conversion de puissance selon la revendication 1 ou 2, comprenant en outre
deux résistances (1102, 1103; 1202, 1203) montées en série qui sont prévues sur le côté d'entrée de chacun des premier et deuxième circuits onduleurs/de décalage de niveau (1101 - 1104, 1150; 1201 - 1204, 1150), et
une diode (1106; 1206) qui est connectée entre un point de connexion des deux résistances (1102, 1103; 1202, 1203) et une borne sur un côté négatif d'une alimentation en courant de commande (1001) de sorte qu'un courant circule vers le point de connexion.

9. Dispositif de conversion de puissance selon l'une quelconque des revendications 1 à 8, dans lequel
une alimentation en courant configurée pour activer les premier et deuxième circuits onduleurs/de décalage de niveau (1101 - 1104, 1150; 1201 - 1204, 1150) et le circuit différentiel (1301 - 1305) est une alimentation en courant continu ayant un potentiel le plus faible d'un circuit de commande (1010) destiné à entraîner la charge à courant continu ou d'un circuit destiné à commander une unité de circuit pour effectuer la conversion en le pseudo courant alternatif avec des fréquence et amplitude quelconques, et un potentiel supérieur au potentiel le plus faible.

10. Dispositif de conversion de puissance selon la revendication 9, dans lequel
des potentiels sont rendus égaux, les potentiels étant:

un potentiel sur un côté négatif de l'alimentation en courant continu pour activer les premier et deuxième circuits onduleurs/de décalage de niveau (1101 - 1104, 1150; 1201 - 1204, 1150) et le circuit différentiel (1301 - 1305), un potentiel sur le côté négatif de l'alimentation en courant continu configuré pour activer et commander un moyen destiné à réduire une composante harmonique dans le courant de l'alimentation en courant alternatif (1001) ou à commander la correction du facteur de puissance, et

un potentiel sur le côté négatif de l'alimentation en courant continu configuré pour activer et commander le circuit de commande (1010) pour la charge à courant continu ou ladite unité de circuit pour réaliser une conversion en le pseudo courant alternatif avec des fréquence et amplitude quelconques.

11. Dispositif de conversion de puissance selon l'une quelconque des revendications 1 à 10, dans lequel

des constantes de circuit des premier et deuxième circuits onduleurs/de décalage de niveau (1101 - 1104, 1150; 1201 - 1204, 1150) et du circuit différentiel (1301 - 1305) sont réglées de telle sorte qu'un gain de chacun des premier et deuxième circuits onduleurs/de décalage de niveau (1101 - 1104, 1150; 1201 - 1204, 1150) est inférieur à un gain du circuit différentiel (1301 - 1305).

12. Dispositif de conversion de puissance selon l'une quelconque des revendications 3 à 6, comprenant en outre une diode (1106; 1206) qui est connectée entre le point de connexion des deux résistances (1102, 1103; 1202, 1203) et la borne sur le côté négatif de l'alimentation en courant de commande (1001) de sorte qu'un courant circule vers le point de connexion.

*Fig.1*

EP 2 690 776 B1

*Fig.2*

EP 2 690 776 B1

*Fig.3*

Fig.4

EP 2 690 776 B1

*Fig.5*

EP 2 690 776 B1

Fig.6

## REFERENCES CITED IN THE DESCRIPTION

### Patent documents cited in the description

- JP 2003079050 A
- JP 2003250298 A
- US 5777866 A
- EP 0695679 A1
- US 5498984 A